# EUROPÄISCHE PATENTSCHRIFT

(11) **EP 1 346 505 B1**
(45) Veröffentlichungstag und Bekanntmachung des Hinweises auf die Patenterteilung: **29.03.2006**
(21) Anmeldenummer: 01978146.7
(22) Anmeldetag: 17.09.2001
(51) Int. Cl.: H04L 7/00

(54) **VERFAHREN ZUR SYNCHRONISIERUNG EINER MEHRZAHL VON BUSSYSTEMEN UND HIERMIT KORRESPONDIERENDES HIERARCHISCHES MEHRBUSSYSTEM**
METHOD FOR SYNCHRONIZING A PLURALITY OF BUS SYSTEMS AND CORRESPONDING HIERARCHICAL MULTIPLE BUS SYSTEM
PROCEDE POUR SYNCHRONISER PLUSIEURS SYSTEMES DE BUS ET SYSTEME DE BUS HIERARCHIQUE CORRESPONDANT

(30) Priorität: 28.09.2000 DE 10048191
(43) Veröffentlichungstag der Anmeldung: 24.09.2003
(73) Patentinhaber: SIEMENS AKTIENGESELLSCHAFT, 80333 München (DE)
(72) Erfinder: KIESEL, Martin, 91099 Poxdorf (DE); SEEGER, Guido, 91083 Baiersdorf (DE); WANNER, Dietmar, 91058 Erlangen (DE); ZEITLER, Michael, 91074 Herzogenaurach (DE)
(86) Internationale Anmeldenummer: PCT/DE2001/003578
(87) Internationale Veröffentlichungsnummer: WO 2002/028003

(56) Entgegenhaltungen:
- DE-A- 19 932 635
- US-A- 4 503 490
- US-A- 5 988 846

## Beschreibung

Die vorliegende Erfindung bezieht sich auf Verfahren zur Synchronisierung einer Mehrzahl von Bussystemen, wobei jedes Bussystem mindestens eine Sendeeinheit und eine Empfangseinheit aufweist und wobei in jedem Bussystem einer Empfangseinheit von der Sendeeinheit zyklisch ausgesandte Synchronisationssignale übermittelt werden, sowie ein hiermit korrespondierendes hierarchisches Mehrbussystem.

Derartige Synchronisierverfahren für Bussysteme und die korrespondierenden Empfangseinheiten sind allgemein bekannt. Sie werden unter anderem in Feldbussystemen, z.B. dem PROFIBUS, oder anderen Bussystemen wie etwa dem Ethernet eingesetzt. Feldbussysteme sind verteilte Steuerungssysteme, die in der Regel eine Sendeeinheit (Kopfbaugruppe, Busmaster) und eine Vielzahl von Empfangseinheiten (Slaves) aufweisen. Die Ansteuerung der einzelnen Slavebaugruppen geschieht in der Regel dadurch, dass die Sendeeinheit den Empfangseinheiten ein Befehlstelegramm übermittelt. Bei Empfang des Befehlstelegramms geben die Empfangseinheiten Sollwerte an eine gesteuerte technische Anlage aus, die ihnen zuvor von der Sendeeinheit übermittelt worden sind. Gleichzeitig lesen sie Istwerte von der gesteuerten technischen Anlage ein, welche sie nachfolgend an die Sendeeinheit übermitteln. Die Sendeeinheit errechnet dann neue Sollwerte, die sie den einzelnen Empfangseinheiten übermittelt, so dass diese für das nächste Befehlstelegramm bereit sind.

Die Befehlstelegramme werden von der Sendeeinheit zeitlich äquidistant gesendet. Aus den Befehlstelegrammen sind daher Synchronisationssignale ableitbar, mittels derer die Empfangseinheiten mit der Sendeeinheit synchronisierbar sind.

Für eine Realisierung größerer vernetzter Systeme auf der Basis solcher Bussysteme oder Feldbussysteme ergibt sich häufig die Notwendigkeit einer Synchronisierung mehrerer separater Bussysteme. Dabei ist es erwünscht, auch unterschiedliche Bussysteme miteinander zu kombinieren und damit auch zu synchronisieren.

Dabei kommt einer Hierarchisierung von Bussystemen große Bedeutung zu, z.B. im Rahmen eines dezentralen Antriebskonzeptes, wo in der Regel eine Steuerung, mehrere Antriebe sowie Leistungsteile miteinander kommunizieren müssen. Gerade im Bereich numerisch gesteuerter industrieller Bearbeitungsmaschinen, beispielsweise Werkzeugmaschinen und Roboter, mit einer Mehrzahl interpolierender Achsen ergibt sich die Anforderung einer durchgängigen Taktsynchronisation, bei Bedarf auch mit unterschiedlichen Bussystemen. Letzteres ist vor allem zur Erhöhung der Flexibilität und der Einsatzbreite wünschenswert.

In diesem Zusammenhang ist aus der Druckschrift DE 199 32 635 A1 ein Synchronisierverfahren für eine Empfangseinheit bekannt. Die Empfangseinheit wird mit einer Sendeeinheit dadurch genauer synchronisiert, dass anhand von von der Sendeeinheit ausgesandten Synchronisationssignalen ein Taktgeber einer phasenverriegelten Schleife nachgeregelt wird. Ein Phasenregler integriert momentane Phasenfehler zu einem Integrationswert auf und der Integrationswert wird nur zu einem Integrationsbruchteil ausgeregelt, der kleiner als eins ist.

Darüber hinaus ist aus der Druckschrift US 4,503,490 ein verteiltes Zeitgebersystem bekannt. Das Zeitgebersystem besitzt eine zentrale Taktschaltung zur Bereitstellung einer fortlaufenden Sequenz von Systemtaktsignalen, eine Vielzahl von Prozessabschnittstaktschaltungen, die in unterschiedlichen Prozesskomponenten angeordnet sind und Mittel zum übertragen der fortlaufenden Sequenz von Systemtaktsignalen zu den Prozessabschnitttaktschaltungen als Abschnittsmastertaktsignale. Jede Abschnittstaktschaltung erzeugt Abschnittstaktsignale für ihren entsprechenden Prozessabschnitt.

Aufgabe der vorliegenden Erfindung ist es dementsprechend, ein Verfahren zur Synchronisation einer Mehrzahl von Bussystemen zu schaffen.

Gemäß der vorliegenden Erfindung wird diese Aufgabe gelöst durch ein Verfahren zur Synchronisierung einer Mehrzahl von Bussystemen, wobei jedes Bussystem mindestens eine Sendeeinheit und eine Empfangseinheit aufweist, wobei in jedem Bussystem einer Empfangseinheit von der zugehörigen Sendeeinheit zyklisch ausgesandte Synchronisationssignale übermittelt werden, wobei eine Empfangseinheit eines ersten Bussystems die Synchronisationssignale einem Phasenregler einer phasenverriegelten Schleife mit einem Taktgeber zuführt, und wobei der Phasenregler beim Empfang der Synchronisationssignale momentane Phasenfehler ermittelt und den Taktgeber derart nachregelt, dass der Taktgeber zwischen zwei Synchronisationssignalen eine Sollanzahl von Taktsignalen ausgibt, wobei jeder Sendeeinheit eines Bussystems ein zentraler Takt vorgegeben wird, aus dem jede Sendeeinheit die jeweiligen Synchronisationssignale zur zyklischen Übermittlung an eine zugeordnete Empfangseinheit generiert, und wobei die Sollanzahl von Taktsignalen einer Sendeeinheit eines anderen Bussystems als zentraler Takt vorgegeben wird.

Durch eine solche Synchronisation zweier oder mehrerer Sendeeinheiten bzw. Busmaster zueinander wird unter anderem ein Parallelbetrieb von Bussen ermöglicht.

Die Sendeeinheiten werden von einem zentralen Takt gespeist. Gemäß des vorgegebenen Takts generiert jede Sendeeinheit die entsprechende Synchronisationsinformation mittels den erforderlichen Telegrammen auf dem jeweiligen Bus. Dieses Prinzip ist unabhängig vom jeweiligen Bussystem, so dass sowohl gleiche Bussysteme als auch verschiedene Bussysteme synchron zueinander betrieben werden können.

In der Praxis verbleibt zwischen dem Übermitteln der eingelesenen Istwerte an die Sendeeinheit und dem Übermitteln der Sollwerte an die Empfangseinheiten einerseits und dem Übermitteln des nächsten Befehlstelegramms andererseits ein zeitlicher Spielraum. Dieser wird in der Regel für sogenannte a-zyklische Telegramme genutzt. Hierbei kann es geschehen, dass aufgrund von Verzögerungen durch die azyklischen Telegramme einzelne Befehlstelegramme verspätet gesendet werden. Der Empfang derart verspätet gesendeter Befehlstelegramme bewirkt eine fehlerhafte Nachsynchronisation der Empfangseinheiten. Zu deren Vermeidung ist es bekannt, einen Phasenregler einer phasenverriegelten Schleife vorzusehen.

Dabei führt eine Empfangseinheit eines Bussystems die Synchronisationssignale dem Phasenregler einer phasenverriegelten Schleife mit einem Taktgeber zu, wobei der Phasenregler beim Empfang der Synchronisationssignale momentane Phasenfehler ermittelt und den Taktgeber derart nachregelt, dass der Taktgeber zwischen zwei Synchronisationssignalen eine Sollanzahl von Taktsignalen ausgibt (vgl. DE 199 32 635).

Es hat sich gemäß der vorliegenden Erfindung nun als besonders vorteilhaft herausgestellt, wenn die über die erwähnte phasenverriegelte Schleife generierte Sollanzahl von Taktsignalen allen Sendeeinheiten der Bussysteme als zentraler Takt vorgegeben wird.

Wenn diese Sollanzahl von Taktsignalen einer Sendeeinheit eines anderen Bussystems als zentraler Takt vorgegeben wird, so lässt sich auf besonders einfache und effektive Weise eine Hierarchisierung von Bussystemen erzielen.

Damit wird eine Synchronisation einer Sendeeinheit bzw. eines Busmasters auf eine Empfangseinheit bzw. einen Busslave und damit die gewünschte Hierarchisierung von Bussen ermöglicht. Eine Empfangseinheit an einem Bus empfängt die Synchronisationsinformation. Mittels einer phasenverriegelten Schleife wird diese Taktinformation gefiltert und werden fehlende Takte (z.B. durch Telegrammzerstörung auf dem Bus) regeneriert. Dieser nun "saubere" Takt wird wiederum zu einer Sendeeinheit bzw. einem Busmaster eines anderen Busses geführt, welcher die entsprechende Taktinformation mittels den erforderlichen Telegrammen auf dem jeweiligen Bus generiert. Diese Prinzip ist wiederum unabhängig vom jeweiligen Bussystem, so dass sowohl mehrere gleiche Busse oder auch verschiedene Bussysteme hierarchisch synchron zueinander betrieben werden können.

Um eine hinreichende Genauigkeit der Synchronisierung einer Empfangseinheit mit der Sendeeinheit eines anderen Bussystems zu erreichen, wird vorgeschlagen, dass der Phasenregler die momentanen Phasenfehler zu einem Integrationswert aufintegriert und dass der Integrationswert zu einem Integrationsbruchteil ausgeregelt wird, wobei der Integrationsbruchteil kleiner als eins ist.

Um einen Betrieb verschiedener Bussysteme mit unterschiedlichen Taktperioden zu ermöglichen, hat es sich als günstig herausgestellt, wenn vor der Ansteuerung einer Sendeeinheit mit einem zentralen Takt eine Taktteilung erfolgt.

Alternativ wird vor der Ansteuerung einer Sendeeinheit mit einem zentralen Takt eine Frequenzvervielfachung vorgenommen, insbesondere innerhalb der phasenverriegelten Schleife.

Wird erfindungsgemäß zwischen den die jeweilige Sendeeinheit bzw. den jeweiligen Busmaster speisenden Takt und den eigentlichen Busmaster ein Taktteiler eingebaut, so können die jeweils betrachteten Bussysteme auch mit unterschiedlichen Bustaktperiodendauern betrieben werden und trotzdem dabei synchron sein. Durch die Taktteilung können nur niederfrequentere Taktperiodendauern in den jeweiligen nachgeschalteten Busmaster eingespeist werden.

Da die oben beschriebene phasenverriegelte Schleife (PLL) jedoch auch höherfrequentere Takte als den von der PLL ursprünglich empfangenen Takt erzeugen kann, ist es somit auch möglich höherfrequentere Takte in den jeweiligen nachgeschalteten Busmaster bzw. die Sendeeinheit einzuspeisen.

Weiter hat es sich als günstig erwiesen, für eine Kompensation von Laufzeiteffekten bei der Synchronisation den jeweiligen von der phasenverriegelten Schleife generierten zentralen Takt um die Laufzeit eines empfangenen Takttelegramms verfrüht vorzugeben.

Der Taktzeitpunkt eines Takttelegramms stellt das Telegrammende dar, da erst nach vollständigem Empfang eines Telegramms dieses als solches decodiert werden kann. Die von der PLL erzeugten Takte sind dann synchron zu diesem Takttelegrammende. Soll nun ein Takttelegramm synchron zu den empfangenen Takttelegrammen bzw. der PLL abgesendet werden, so kann dieses um die Laufzeit des Takttelegramms verfrüht geschehen, damit das Takttelegrammende zeitlich mit dem Telegrammende eines empfangenen Takttelegramms bzw. mit den von der PLL erzeugten Takten zusammenfällt. Auf diese Weise können z.B. bei hierarchischen Bussystemen Busmaster/ Sendeeinheit und Busslave/Empfangseinheit ohne Phasenverschiebung zueinander betrieben werden.

Zur hierarchischen Synchronisierung einer Mehrzahl von Bussystemen werden demnach vorteilhafterweise mehrere phasenverriegelte Schleifen mehrerer Bussysteme kaskadiert.

Dabei hat es sich als günstig erwiesen, wenn zur Vermeidung von Schwingungen der phasenverriegelten Schleifen der Frequenzgang jeder phasenverriegelten Schleife eine Verstärkung kleiner oder gleich eins aufweist.

Mit dem vorangehend dargestellten erfindungsgemäßen Verfahren lässt sich somit eine Synchronisation unterschiedlicher Bussysteme erreichen, wobei auch eine Taktsynchronisation trotz verschiedener Bussysteme möglich ist. Dadurch wird gegenüber bekannten Konzepten eine höhere Flexibilität sowie Erhöhung der Einsatzbreite mit durchgängiger Taktsynchronisation erreicht.

Diese Flexibilität wird weiter erhöht durch unterschiedliche, aber synchrone Bustaktperiodendauern (z.B. einem Antriebsbus mit hohen Anforderungen und einem anderen Bus für einfache Peripherie mit niedrigen Anforderungen bezüglich Reaktionszeiten/Bustaktperiodendauer/Dynamik usw.). Ein Performance-Verlust durch mögliche Laufzeiteffekte der Takttelegramme kann ebenfalls vermieden werden.

Weitere Vorteile und Einzelheiten der Erfindung ergeben sich anhand des folgenden vorteilhaften Ausführungsbeispiels und in Verbindung mit den Figuren. Dabei sind Elemente mit gleicher Funktionalität mit den gleichen Bezugszeichen gekennzeichnet. Es zeigen:
- FIG 1: ein Blockschaltbild eines verteilten Steuerungssystems,
- FIG 2: ein Blockschaltbild zweier synchronisierter Bussysteme zur Darstellung der topologischen Verhältnisse,
- FIG 3: ein Blockschaltbild einer phasenverriegelten Schleife und
- FIG 4: ein Zeitdiagramm der Laufzeitkompensation.

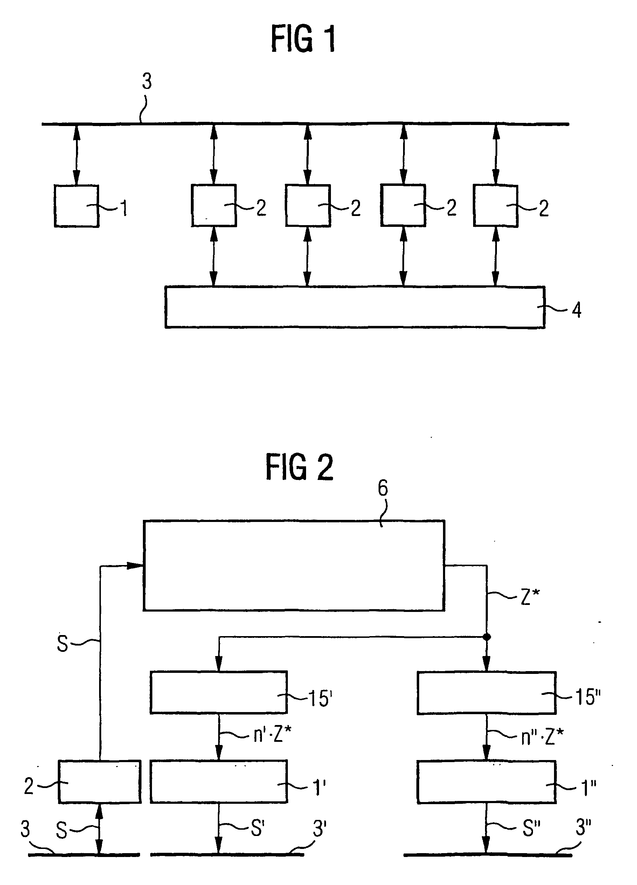

Gemäß FIG 1 weist ein verteiltes Steuerungssystem eine Sendeeinheit 1 und Empfangseinheiten 2 auf, die über ein Bussystem 3.miteinander verbunden sind. Die Sendeeinheit 1 sendet zyklisch Telegramme an die Empfangseinheiten 2, welche entsprechend auf die empfangenen Telegramme reagieren. Beispielsweise lesen die Empfangseinheiten 2 von einer gesteuerten technischen Anlage bzw. Applikation 4 Eingangsgrößen ein und geben Ausgangsgrößen an die technische Anlage bzw. Applikation 4 aus. Dies ist in FIG 1 durch die Pfeile zwischen den Empfangseinheiten 2 und der technischen Anlage/Applikation 4 angedeutet.

Die Kommunikation zwischen der Sendeeinheit 1 und den Empfangseinheiten 2 erfolgt in der Regel nach folgendem, zyklisch abgearbeiteten Schema:

Zunächst übermittelt die Sendeeinheit 1 den Empfangseinheiten 2 Ausgangsgrößen, die an die technische Anlage/Applikation 4 ausgegeben werden sollen. Dann übermittelt sie ein Befehlstelegramm an die Empfangseinheiten 2. Bei Übermittlung des Befehlstelegramms geben die Empfangseinheiten 2 die Ausgangsgrößen an die technische Anlage 4 aus und lesen Eingangsgrößen von der technischen Anlage 4 ein. Sodann werden die eingelesenen Eingangsgrößen von der Sendeeinheit 1 abgefragt.

Im Idealfall wird das obenstehende Schema streng zyklisch und zeitlich streng äquidistant abgearbeitet. Insbesondere die Befehlstelegramme können daher als Synchronisationssignale S verwendet werden bzw. aus den Befehlstelegrammen Synchronisationssignale S abgeleitet werden. Mittels der Synchronisationssignale S können sich dann die Empfangseinheiten 2 mit der Sendeeinheit 1 synchronisieren.

In der Darstellung nach FIG 2 ist die topologische Anordnung einer vorteilhaften Verschaltung dreier verschiedener Bussysteme 3, 3' und 3" gezeigt, die nach dem erfindungsgemäßen Verfahren miteinander synchronisiert werden. Während an dem Bus 3 eine angeschlossene Empfangseinheit/Slave 2 gezeigt ist, die von dem Bus 3 Synchronisationssignale S einer (nicht gezeigten) Sendeeinheit/ Busmaster empfängt, ist für den zweiten Bus 3' eine Sendeeinheit/Busmaster 1' gezeigt, welche Synchronisationssignale S' an den zweiten Bus 3' sendet. Das gleiche tut eine Sendeeinheit/Busmaster 1" für den dritten Bus 3".

Es handelt sich demnach um den Fall einer Hierachisierung von Bussystemen nach der Erfindung. Ohne eine erfindungsgemäße Synchronisierung können die jeweiligen Synchronisationssignale S, S' und S" sehr unterschiedliche Periodendauern besitzen.

Zur Synchronisierung werden nun die Sendeeinheiten/Busmaster 1' und 1" von Bus 3' und 3" auf den Takt der Empfangseinheit/Slave 2 von Bus 3 synchronisiert. Dazu wird aus dem Synchronisationssignal S über eine phasenverriegelte Schleife 6 ein zentraler Takt Z* generiert, mit dem beide Bussysteme 3*'* und 3" beaufschlagt werden.

Dieser zentrale Takt Z* kann direkt oder über optionale jeweilige Frequenzteiler 15', 15" zur Ansteuerung der jeweiligen Sendeeinheiten/Busmaster 1', 1" der Bussysteme 3', 3" dienen. Die Frequenzteiler 15', 15" können unterschiedlichen Teilungsverhältnisse n', n" haben, so dass die beiden Busse 3', 3" auch mit unterschiedlichen Busperiodendauern synchron betrieben werden können. Außer einer Taktteilung kommt auch eine Frequenzvervielfachung (n', n" > 1) in Frage, die vor allem über die im folgenden zu erläuternde phasenverriegelte Schleife (PLL) erzeugbar sind. Damit ist es auch möglich, höherfrequente Takte in die jeweilige nachgeschaltete Sendeeinheit/Busmaster einzuspeisen.

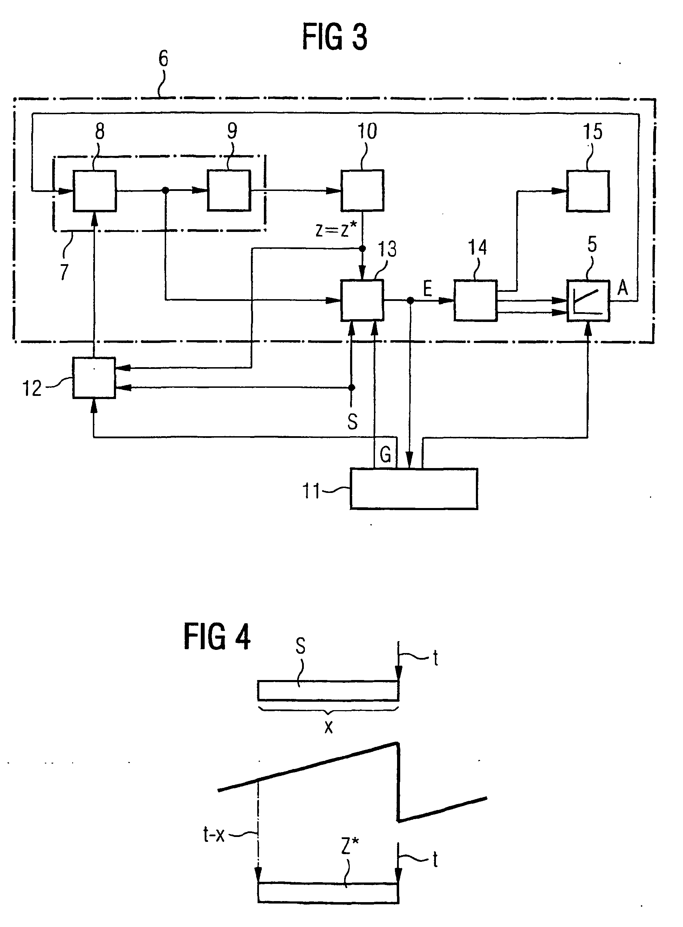

Die von einer Empfangseinheit/Slave 2 empfangenen Synchronisationssignale werden gemäß FIG 3 über einen Busanschlussbaustein einem Phasenregler 5 einer phasenverriegelten Schleife 6 zugeführt. Die phasenverriegelte Schleife 6 weist einen Taktgeber 7 auf. Innerhalb des Taktgebers 7 erzeugt ein Taktgenerator 8 Primärtaktsignale, die einem Frequenzteiler 9 zugeführt werden. Ausgangsseitig gibt der Frequenzteiler 9 die heruntergeteilten Primärtaktsignale als Taktsignale aus. Die Taktsignale werden einem Taktsignalzähler 10 zugeführt.

Bei idealer Regelung des Taktgenerators 8 gibt der Taktgeber 7 zwischen zwei Synchronisationssignalen S exakt eine Sollanzahl Z* von Taktsignalen aus. In der Regel gibt der Taktgeber 7 aber eine Anzahl Z von Taktsignalen aus, welche von der Sollanzahl Z* abweicht. Der Phasenregler 5 ermittelt daher beim Empfang der Synchronisationssignale momentane Phasenfeh-1er E und regelt dann den Taktgeber 7 derart nach, dass er zwischen zwei Synchronisationssignalen S die Sollanzahl Z* von Taktsignalen ausgibt. Dies geschieht wie folgt:

Vor Beginn der Synchronisation, also vor der Ermittlung des ersten momentanen Phasenfehlers E, wird zunächst von einer Steuereinheit 11 einer Ansteuereinheit 12 ein Startsignal vorgegeben. Diese steuert daraufhin den Taktgenerator 8 des Taktgebers 7 an. Wenn der Taktsignalzähler 10 die Sollanzahl Z* von Taktsignalen gezählt hat, übermittelt der Taktsignalzähler 10 ein Signal an die Ansteuereinheit 12. Diese hält daraufhin den Taktgenerator 8 wieder an. Die phasenverriegelte Schleife 6 ist dadurch sozusagen "vorgespannt". Beim Empfang des nächsten Synchronisationssignals, das ebenfalls an die Ansteuereinheit 12 übermittelt wird, startet diese dann den Taktgenerator 8 wieder. Dadurch wird der Taktsignalzähler 10 neu hochgezählt,

Das Erreichen der Sollanzahl Z* sowie das Eintreffen des nächsten Synchronisationssignals S wird an einen Primärtaktzähler 13 gemeldet. Beim Eintreffen des ersten dieser beiden Signale wird der Primärtaktzähler 13 gestartet, beim Eintreffen des zweiten der beiden Signale gestoppt. Der (vorzeichenbehaftete) Zählerstand des Primärtaktzählers 13 ist somit ein direktes Maß für den Fehler zwischen der Taktung des Taktgebers 7 und der Periodizität der Synchronisationssignale S.

Beim Empfang des ersten Synchronisationssignals S nach dem Wiederstarten des Taktgebers 7 wird der Zählerstand des Primärtaktzählers 13 an die Steuereinheit 11 übermittelt. Diese errechnet daraus einen Korrekturwert für die Ansteuerung des Taktgenerators 8 und gibt diesen Korrekturwert direkt dem Phasenregler 5 vor. Dadurch wird der beim ersten Synchronisationszyklus detektierte momentane Phasenfehler E zumindest im wesentlichen ausgeregelt.

In den weiteren Synchronisationszyklen wird der Primärtaktzähler 13 stets in Abhängigkeit vom Synchronisationssignal S. und dem Erreichen der Sollanzahl Z* gesteuert. Beim Eintreffen des ersten dieser beiden Signale wird der Primärtaktzäh-1er 13 gestartet und beim Eintreffen des zweiten dieser beiden Signale gestoppt. Der Zählerstand des Primärtaktzählers 13 wird einem Vergleicher 14 zugeführt.

Der Zählerstand des Primärtaktzählers 13 wird betragsmäßig mit einem Maximalfehler verglichen. Wenn der Zählerstand den Maximalfehler übersteigt, wird ein Auszeitzähler 15 hochgezählt. In diesem Fall wird an den Phasenregler 5 kein Fehlersignal ausgegeben. Der Phasenregler 5 behält sein bisheriges Ausgangssignal bei.

In der Regel wird der Primärtaktzähler 13 bei jeder Übermittlung eines Synchronisationssignals S gestartet bzw. gestoppt. Es ist aber auch möglich, der phasenverriegelten Schleife 6 zusätzlich von der Steuereinheit 11 ein Gültigkeitssignal G zu übermitteln. In diesem Fall wird der Primärtaktzähler 13 nur dann gestartet und gestoppt, wenn das Gültigkeitssignal G anliegt. Es ist ferner möglich, den Primärtaktzähler 13 um einen Phasenversatz bezüglich des Synchronisationssignals S versetzt zu starten und auszuwerten. Letzteres ist vorteilhaft im Hinblick auf die oben beschriebene Kompensation von Laufzeiteffekten (vgl. auch FIG 4).

Vorteilhaft für den Aufbau von hierarchischen Bussystemen - wie in FIG 2 gezeigt - ist eine Änderung der Regelparameter der phasenverriegelten Schleife 6 der Art, dass der Frequenzgang der PLL 6 möglichst keine oder eine Verstärkung kleiner 1, allenfalls jedoch nur geringe Verstärkungen größer als 1 besitzt. Dies ist nötig, damit bei der Hierarchisierung von Bussystemen der Gesamtfrequenzgang von mehreren in Serie geschalteten PLL's 6 keine ausgeprägte Resonanzfrequenz besitzt, bei der die PLL's 6 leicht zum Schwingen anregt werden könnten.

Gemäß FIG 2 ist es prinzipiell auch möglich, die beiden Bussysteme 3', 3" ohne eine Hierarchisierung parallel zu betreiben, indem eine starre Ausgangstaktsignalerzeugung ohne Synchronisation auf eine Bus-Empfangseinheit 2 erfolgt. Die PLL 6 fungiert dann als autonomer Taktgenerator zur Erzeugung eines gemeinsamen zentralen Taktes Z*.

Soll das Takttelegramm synchron zu den empfangenen Takttelegrammen bzw. der PLL 6 abgesendet werden, so kann dieses um die Laufzeit des Takttelegramms verfrüht geschehen. Dieser Zusammenhang ist in der Darstellung nach FIG 4 veranschaulicht.

Gezeigt ist ein empfangenes Takttelegramm S, welches zum Taktzeitpunkt t komplett empfangen ist. Erst zu diesem Zeitpunkt kann das Takttelegramm decodiert werden. Damit das Takttelegrammende eines zentralen Taktes Z* zeitlich mit dem Telegrammende eines empfangenen Takttelegramms S bzw. mit den von der PLL 6 erzeugten Takten zusammenfällt, wird nun das Takttelegramm des zentralen Taktes Z* um eine definierte Zeit x, vorteilhaft die Laufzeit des empfangenen Takttelegramms, verfrüht abgesandt. Dadurch werden Laufzeiteffekte bei der Synchronisation verschiedener Bussysteme vermieden und es können bei hierarchischen Bussystemen Sendeeinheiten/ Busmaster und Empfangseinheit/Busslave ohne Phasenverschiebung zueinander synchron betrieben werden.

## Patentansprüche

1. Verfahren zur Synchronisierung einer Mehrzahl von Bussystemen (3',3"),
- wobei jedes Bussystem (3',3") mindestens eine Sendeeinheit (1',1") und eine Empfangseinheit (2) aufweist,
- wobei in jedem Bussystem (3',3") einer Empfangseinheit (2) von der zugehörigen Sendeeinheit zyklisch ausgesandte Synchronisationssignale (S) übermittelt werden,
- wobei eine Empfangseinheit (2) eines ersten Bussystems (3) die Synchronisationssignale (S) einem Phasenregler (5) einer phasenverriegelten Schleife (6) mit einem Taktgeber (7) zuführt, und
- wobei der Phasenregler (5) beim Empfang der Synchronisationssignale (S) momentane Phasenfehler (E) ermittelt und den Taktgeber (7) derart nachregelt, dass der Taktgeber (7) zwischen zwei Synchronisationssignalen (S) eine Sollanzahl (Z*) von Taktsignalen ausgibt,
**dadurch gekennzeichnet, dass** jeder Sendeeinheit (1',1") eines Bussystems (3',3") ein zentraler Takt (Z*) vorgegeben wird, aus dem jede Sendeeinheit (1',1") die jeweiligen Synchronisationssignale (S',S") zur zyklischen Übermittlung an eine zugeordnete Empfangseinheit generiert, wobei die Sollanzahl (Z*) von Taktsignalen einer Sendeeinheit (1',1") eines anderen Bussystems (3',3") als zentraler Takt vorgegeben wird.

2. Verfahren zur Synchronisierung einer Mehrzahl von Bussystemen nach Anspruch 1, **dadurch gekenn**- **zeichnet**, **dass** der Phasenregler (5) die momentanen Phasenfehler (E) zu einem Integrationswert aufintegriert und dass der Integrationswert zu einem Integrationsbruchteil ausgeregelt wird, wobei der Integrationsbruchteil kleiner als eins ist.

3. Verfahren zur Synchronisierung einer Mehrzahl von Bussystemen nach einem der Ansprüche 1 bis 2, **dadurch gekennzeichnet, dass** vor der Ansteuerung einer Sendeeinheit (1' ,1") mit einem zentralen Takt (Z*) eine Taktteilung (15',15") erfolgt.

4. Verfahren zur Synchronisierung einer Mehrzahl von Bussystemen nach Anspruch 1 bis 3, **dadurch gekenn**- **zeichnet**, **dass** vor der Ansteuerung einer Sendeeinheit (1',1") mit einem zentralen Takt (Z*) eine Frequenzvervielfachung erfolgt, insbesondere innerhalb der phasenverriegelten Schleife (6).

5. Verfahren zur Synchronisierung einer Mehrzahl von Bussystemen nach einem der Ansprüche 1 bis 4, wobei das Telegrammende eines Takttelegramms den jeweiligen Taktzeitpunkt (t) darstellt, **dadurch gekennzeichnet, dass** der jeweilige von der phasenverriegelten Schleife generierte zentrale Takt (Z*) um die Laufzeit (x) eines empfangenen Takttelegramms verfrüht vorgegeben wird.

6. Verfahren zur hierarchischen Synchronisierung einer Mehrzahl von Bussystemen nach einem der Ansprüche 1 bis 5, **da-durch gekennzeichnet**, **dass** mehrere phasenverriegelte Schleifen mehrerer Bussysteme kaskadiert werden.

7. Verfahren zur hierarchischen Synchronisierung einer Mehrzahl von Bussystemen nach einem der Ansprüche 1 bis 6, **da-durch gekennzeichnet**, **dass** der Frequenzgang jeder phasenverriegelten Schleife (6) eine Verstärkung kleiner oder gleich eins aufweist.

8. Hierarchisches Mehrbussystem mit
- einer Mehrzahl von synchronisierbaren Bussystemen (3',30"), wobei jedes Bussystem (3',3") mindestens eine Sendeeinheit (1',1") und eine Empfangseinheit (2) aufweist, und wobei in jedem Bussystem (3',3") einer Empfangseinheit (2) von der zugehörigen Sendeeinheit zyklisch ausgesandte Synchronisationssignale (S) übermittelbar sind, und
- einer phasenverriegelten Schleife (6) einschließlich Phasenregler (5) und Taktgeber (7), wobei eine Empfangseinheit (2) eines ersten Bussystems (3) die Synchronisationssignale (S) dem Phasenregler (5) der phasenverriegelten Schleife (6) mit dem Taktgeber (7) zuführt, und wobei der Phasenregler (5) beim Empfang der Synchronisationssignale (S) momentane Phasenfehler (E) ermittelt und den Taktgeber (7) derart nachregelt, dass der Taktgeber (7) zwischen zwei Synchronisationssignalen (S) eine Sollanzahl (Z*) von Taktsignalen ausgibt,
**dadurch gekennzeichnet, dass**
- jeder Sendeeinheit (1',1") eines Bussystems (3', 3") ein zentraler Takt (Z*) vorgebbar ist, aus dem durch jede Sendeeinheit (1',1") die jeweiligen Synchronisationssignale (S',S") zur zyklischen Übermittlung an eine zugeordnete Empfangseinheit generierbar sind, wobei die Sollanzahl (Z*) von Taktsignalen einer Sendeeinheit (1',1") eines anderen Bussystems (3', 3") als zentraler Takt vorgegeben ist.

## Claims

1. Method for synchronizing a plurality of bus systems (3', 3")
- where each bus system (3', 3") has at least one transmission unit (1',1") and a reception unit (2),
- where, in each bus system (3', 3"), cyclically transmitted synchronization signals (S) are transmitted to a reception unit (2) by the associated transmission unit,
- where a reception unit (2) in a first bus system (3) supplies the synchronization signals (S) to a phase regulator (5) in a phase-locked loop (6) having a clock transmitter (7), and
- where, upon receipt of the synchronization signals (S), the phase regulator (5) ascertains instantaneous phase errors (E) and readjusts the clock transmitter (7) such that the clock transmitter (7) outputs a nominal number (Z*) of clock signals between two synchronization signals (S),
**characterized in that** a central clock (Z*) is prescribed for each transmission unit (1', 1") in a bus system (3', 3"), and each transmission unit (1', 1") uses this central clock to generate the respective synchronization signals (S',S") for cyclic transmission to an associated reception unit, the nominal number (Z*) of clock signals being prescribed as the central clock for a transmission unit (1', 1") in another bus system (3', 3").

2. Method for synchronizing a plurality of bus systems according to Claim 1, **characterized in that** the phase regulator (5) integrates the instantaneous phase errors (E) to form an integration value, and **in that** the integration value is corrected to form an integration fraction, with the integration fraction being less than one.

3. Method for synchronizing a plurality of bus systems according to Claim 1 or 2, **characterized in that** clock division (15', 15") is effected before a transmission unit (1', 1") is driven using a central clock (Z*).

4. Method for synchronizing a plurality of bus systems according to Claim 1 to 3, **characterized in that** frequency multiplication is effected, in particular within the phase-locked loop (6), before a transmission unit (1', 1") is driven using a central clock (Z*).

5. Method for synchronizing a plurality of bus systems according to one of Claims 1 to 4, where the message end of a clock message represents the respective clock instant (t), **characterized in that** the respective central clock (Z*) generated by the phase-locked loop is prescribed so that it is advanced by the delay time (x) of a received clock message.

6. Method for hierarchically synchronizing a plurality of bus systems according to one of Claims 1 to 5, **characterized in that** a plurality of phase-locked loops in a plurality of bus systems are cascaded.

7. Method for hierarchically synchronizing a plurality of bus systems according to one of Claims 1 to 6, **characterized in that** the frequency response of each phase-locked loop (6) has a gain of less than or equal to unity.

8. Hierarchical multibus system having
- a plurality of synchronizable bus systems (3', 3"), where each bus system (3', 3") has at least one transmission unit (1', 1") and a reception unit (2), and where, in each bus system (3', 3"), cyclically transmitted synchronization signals (S) can be transmitted to a reception unit (2) by the associated transmission unit, and
- a phase-locked loop (6) including phase regulator (5) and clock transmitter (7), where a reception unit (2) in a first bus system (3) supplies the synchronization signals (S) to the phase regulator (5) in the phase-locked loop (6) having the clock transmitter (7), and where, upon receipt of the synchronization signals (S), the phase regulator (5) ascertains instantaneous phase errors (E) and readjusts the clock transmitter (7) such that the clock transmitter (7) outputs a nominal number (Z*) of clock signals between two synchronization signals (S),
**characterized in that**
- a central clock (Z*) can be prescribed for each transmission unit (1', 1") in a bus system (3', 3"), the respective synchronization signals (S', S") for cyclic transmission to an associated reception unit being able to be generated by each transmission unit (1',1") from this central clock, the nominal number (Z*) of clock signals being prescribed as the central clock for a transmission unit (1', 1") in another bus system (3', 3").

## Revendications

1. Procédé de synchronisation de plusieurs systèmes de bus (3', 3"),
- chaque système de bus (3', 3") comportant au moins une unité d'émission (1', 1") et une unité de réception (2),
- dans chaque système de bus (3', 3"), des signaux de synchronisation (S) émis de façon cyclique étant transmis à une unité de réception (2) par l'unité d'émission associée,
- une unité de réception (2) d'un premier système de bus (3) envoyant les signaux de synchronisation (S) à un régulateur de phase (5) d'une boucle à verrouillage de phase (6) qui comprend un générateur d'horloge (7), et
- lors de la réception des signaux de synchronisation (S), le régulateur de phase (5) déterminant des erreurs de phase momentanées (E) et ajustant le générateur d'horloge (7) de telle sorte que le générateur d'horloge (7) délivre un nombre de consigne (Z*) de signaux d'horloge entre deux signaux de synchronisation (S),
**caractérisé par le fait qu'**on prescrit à chaque unité d'émission (1' , 1") d'un système de bus (3', 3") une horloge centrale (Z*) à partir de laquelle chaque unité d'émission (1', 1") produit les signaux de synchronisation respectifs (S', S") pour la transmission cyclique à une unité de réception associée, le nombre de consigne (Z*) de signaux d'horloge étant prescrit comme horloge centrale à une unité d'émission (1', 1") d'un autre système de bus (3', 3").

2. Procédé de synchronisation de plusieurs systèmes de bus selon la revendication 1, **caractérisé par le fait que** le régulateur de phase (5) intègre les erreurs de phase momentanées (E) en une valeur intégrée et que la valeur intégrée est régulée à une fraction d'intégration, la fraction d'intégration étant inférieure à un.

3. Procédé de synchronisation de plusieurs systèmes de bus selon l'une des revendications 1 à 2, **caractérisé par le fait que**, avant la commande d'une unité d'émission (1', 1") avec une horloge centrale (Z*), on effectue une division d'horloge (15',15").

4. Procédé de synchronisation de plusieurs systèmes de bus selon l'une des revendications 1 à 3, **caractérisé par le fait que**, avant la commande d'une unité d'émission (1', 1") avec une horloge centrale (Z*), on effectue une multiplication de fréquence, en particulier à l'intérieur de la boucle à verrouillage de phase (6).

5. Procédé de synchronisation de plusieurs systèmes de bus selon l'une des revendications 1 à 4, la fin d'un télégramme d'horloge représentant l'instant d'horloge respectif (t), **caractérisé par le fait que** l'horloge centrale respective (Z*) produite par la boucle à verrouillage de phase est prescrite avec une avance égale au temps de propagation (x) d'un télégramme d'horloge reçu.

6. Procédé pour la synchronisation hiérarchique de plusieurs systèmes de bus selon l'une des revendications 1 à 5, **caractérisé par le fait que** plusieurs boucles à verrouillage de phase de plusieurs systèmes de bus sont mises en cascade.

7. Procédé pour la synchronisation hiérarchique de plusieurs systèmes de bus selon l'une des revendications 1 à 6, **caractérisé par le fait que** la réponse fréquentielle de chaque boucle à verrouillage de phase (6) présente une amplification inférieure ou égale à un.

8. Système multibus hiérarchique comportant
- plusieurs systèmes de bus (3',3") synchronisables, chaque système de bus (3',3") comportant au moins une unité d'émission (1',1") et une unité de réception (2) et, dans chaque système de bus (3',3"), des signaux de synchronisation (S) émis de façon cyclique étant transmis à une unité de réception (2) par l'unité d'émission associée, et
- une boucle à verrouillage de phase (6) qui comprend un régulateur de phase (5) et un générateur d'horloge (7), une unité de réception (2) d'un premier système de bus (3) envoyant les signaux de synchronisation (S) au régulateur de phase (5) de la boucle à verrouillage de phase (6) qui comprend le générateur d'horloge (7) et, lors de la réception des signaux de synchronisation (S), le régulateur de phase (5) déterminant des erreurs de phase momentanées (E) et ajustant le générateur d'horloge (7) de telle sorte que le générateur d'horloge (7) délivre un nombre de consigne (Z*) de signaux d'horloge entre deux signaux de synchronisation (S),
**caractérisé par le fait que**
- il peut être prescrit à chaque unité d'émission (1',1") d'un système de bus (3',3") une horloge centrale (Z*) à partir de laquelle chaque unité d'émission (1',1") peut produire les signaux de synchronisation respectifs (S', S") pour la transmission cyclique à une unité de réception associée, le nombre de consigne (Z*) de signaux d'horloge étant prescrit comme horloge centrale à une unité d'émission (1',1") d'un autre système de bus (3', 3").
